(11) **EP 1 630 951 B1**

(12) **EUROPEAN PATENT SPECIFICATION**

(45) Date of publication and mention
of the grant of the patent:
**05.03.2008 Bulletin 2008/10**

(51) Int Cl.:
***H03F 1/56*** *(2006.01)*

(21) Application number: **04425635.2**

(22) Date of filing: **26.08.2004**

(54) **Low noise amplifier**

Rauscharmer Verstärker

Amplificateur à faible bruit

(84) Designated Contracting States:
**DE FR GB IT**

(43) Date of publication of application:
**01.03.2006 Bulletin 2006/09**

(73) Proprietor: **STMicroelectronics S.r.l.**
**20041 Agrate Brianza (Milano) (IT)**

(72) Inventor: **Pelleriti, Roberto**
**95125 Catania (IT)**

(74) Representative: **Mittler, Enrico**
**Mittler & C. s.r.l.,**
**Viale Lombardia, 20**
**20131 Milano (IT)**

(56) References cited:
**US-A1- 2002 093 380**       **US-B1- 6 559 717**

EP 1 630 951 B1

**Description**

The present invention refers to a low noise amplifier.

It is generally known that in urban areas where the transmission and reception via satellite of audio signals is limited or not available, land repeaters, used in said systems of transmission and reception of audio signals, have to be produced so as to guarantee maximum reliability. For this reason amplifiers of audio signals used in said systems of transmission and reception must be capable of using audio signals with a wide volume range, from -90dBm to 0dBm, without any degradation of the signal/noise S/(N+I) ratio where with S the power of the input signal is indicated, with N the noise and with I the interference.

To avoid the saturation of the cascade stages in the case of multistage amplifiers, said amplifiers must be capable of reducing the gain when the power of the input signal increases. To keep a good signal/noise ratio the amplifier must present a low noise pattern when the input signal is very low and a good linearity when the input signal is very high, keeping a good input coupling to avoid problems due to the standing waves.

A low noise amplifier of this type is described in US 6600371. The amplifier comprises a first circuit block capable of converting in current a first voltage signal in input to the amplifier, a second circuit block adapted to dividing the current coming from said first block. The second block is controlled by a second voltage signal and the first and the second circuit block provide a variable voltage gain to the amplifier. The amplifier comprises a first and a second resistor and a feedback network; the first resistor is connected to a first output terminal from the second block and to a supply voltage and the second resistor is connected between the first and a second output terminal of said second block. The feedback network is coupled to the first terminal and to the first circuit block and the second terminal is coupled to at least one output terminal of the low noise amplifier. Said low noise amplifier permits good input coupling to be obtained but nevertheless does not assist in an increase of the linearity when the gain decreases. In addition there is a limited reduction of the gain due to the ratio between the resistors.

Another circuit structure of low noise amplifier provides, in addition to the circuit of the amplifier previously described, for a transistor coupled with the first circuit block, constituted by bipolar transistors, to modulate the emitter degeneration resistor so as to reduce the gain. An example is shown in US 6559717. With a circuit structure of this kind there is an increase of the input linearity when the gain is reduced but the input coupling is lost.

In view of the state of the art described, object of the present invention is to provide a low noise amplifier that overcomes the above mentioned inconveniences.

In accordance with the present invention, this object is achieved by means of a low noise amplifier comprising at least one first circuit block capable of amplifying a first voltage signal in input to the amplifier, said first circuit block having at least one first terminal coupled to a first supply voltage by means of first variable resistor means and at least one second terminal coupled with a second supply voltage by means of at least one resistor, said at least one second terminal being coupled to the at least one output terminal of the amplifier and said input voltage signal being applied to at least one further terminal of the first circuit block, said amplifier comprising a feedback network coupled to the at least one output terminal of the amplifier and to said at least one further terminal of the first circuit block, characterised in that it comprises second circuit means placed between said second supply voltage and said at least one further terminal of the first circuit block and adapted to compensating the variations in value of said first variable resistor means to ensure a substantially constant input resistance of said amplifier.

Thanks to the present invention it is possible to produce a low noise amplifier that presents a constant input resistance, good linearity characteristics in case of high input signals and a good noise pattern in case of low input signals.

The characteristics and advantages of the present invention will appear evident from the following detailed description of an embodiment thereof, illustrated as non-limiting example in the enclosed drawings, in which:

Figure 1 is a diagram of a low noise amplifier in accordance with the invention;
Figure 2 is a circuit diagram of a circuit implementation of a low noise amplifier according to a first embodiment of the invention;
Figure 3 is another circuit diagram of a circuit implementation of a low noise amplifier according to a variant of the first embodiment of the invention;
Figure 4 is a further circuit diagram of a circuit implementation of a low noise amplifier according to another variant of the first embodiment of the invention;
Figure 5 is yet another circuit diagram of a circuit implementation of a low noise amplifier in accordance with a second embodiment of the invention;
Figure 6 is yet a further circuit diagram of a circuit implementation of a low noise amplifier in accordance with a variant of the second embodiment of the invention;
Figure 7 is a graph of the trend of the voltage gain upon variation of the voltage VAGC;
Figure 8 is a graph of the trend of the resistances $R_{in1}$, $R_{in2}$ and $R_{in}$ upon variation of the voltage VAGC;
Figure 9 is a graph of the trend of the return losses;

Figures 10 and 11 are graphs respectively of the intercept IIP3 and of the noise pattern F for the circuit of Figure 4 in case of maximum gain;

Figures 12 and 13 are graphs respectively of the intercept IIP3 and of the noise pattern F for the circuit of Figure 4 in case of minimum gain.

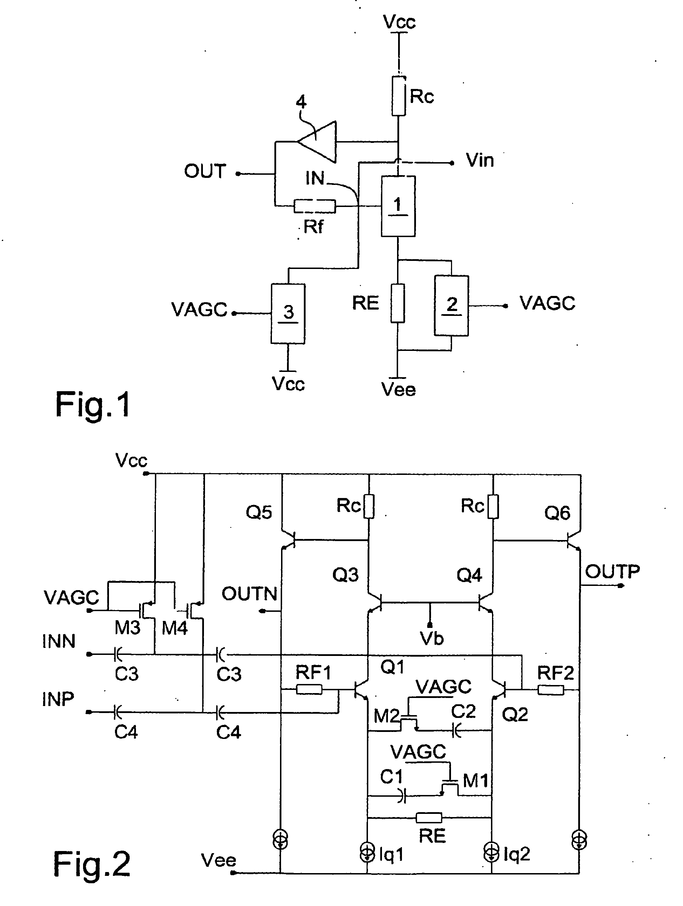

With reference to Figure 1 a diagram of a low noise amplifier comprising at least one first circuit block 1 capable of converting in current a first voltage signal Vin in input to the amplifier is shown. The first circuit block 1, which preferably is constituted by a bipolar or MOS transistor, has a first terminal, the emitter terminal in the case of a bipolar npn transistor, coupled to a first supply voltage Vee by means of a first resistor RE and a second terminal, the collector terminal again in the case of a bipolar npn transistor, coupled with a second supply voltage Vcc by means of a second resistor Rc. The second terminal is coupled to the output terminal of the amplifier by means of a buffer 4 and the first circuit block 1 is adapted to amplifying the voltage signal Vin in input applied to a further terminal IN, the base terminal again in the case of a bipolar transistor npn, of the first circuit block 1. The amplifier comprises a further resistor RF coupled to the output terminal OUT and to the further terminal IN of the first circuit block 1 and first circuit means 2 controlled by a second voltage signal VAGC and adapted to forming with the first resistor RE a variable resistor circuit block. The amplifier comprises second circuit means 3 placed between the second supply voltage Vcc and the further terminal IN of the first circuit block 1, controlled by the second voltage signal VAGC and adapted to compensating the value variations of the above-mentioned variable resistor circuit block RE, 2 to ensure a substantially constant input resistance $R_{in}$ of the amplifier.

A circuit implementation of the low noise amplifier according to a first embodiment of the invention is shown in Figure 2. The circuit block 1 comprises a differential cascode apparatus formed by the bipolar transistors npn Q1-Q4. The transistors Q1, Q3 and the transistors Q2, Q4 have the respective collector and emitter terminals in common, the emitter terminals of the transistors Q1 and Q2 are connected to the leads of the resistor RE and are connected to respective current generators Iq1 and Iq2 while the collector terminals of the transistors Q3 and Q4 are connected to respective resistors Rc connected to the supply Vcc and the base terminals of the transistors Q3 are Q4 are connected to a bias voltage generator Vb. The first circuit means 2 are made up of a first series of a transistor NMOS M1 and a capacitor C1 and a second series of a transistor NMOS M2 and a capacitor C2 placed between the emitter terminals of the transistors Q1 and Q2; the transistors M1 and M2 are commanded by the voltage VAGC. The transistors M1 and M2 are used to change the value of the degeneration resistor connected to the emitter terminals of the transistors Q1 and Q2 by a value 0 (with VAGC=Vcc and M1 and M2 short-circuited) to a value RE (with VAGC=0 and M1 and M2 open). The capacitors C1 and C2 are used to keep the transistors M1 and M2 in the triode region in the conditions in which the voltage VAGC is between the values 0 and Vcc.

The amplifier comprises two bipolar npn transistors Q5 and Q6 whose base terminals are connected to the collector terminals of the transistors Q3 and Q4, whose collector terminals are connected to the supply voltage Vcc and the emitter terminals, that constitute the outputs OUTP and OUTN of the amplifier are connected to the base terminals of the transistors Q1 and Q2 through two resistors RF1 and RF2 of value equal to a resistor $R_F$ and are connected to bias current generators.

The second circuit means 3 comprise a series of a PMOS transistor M3 and a capacitor C3 connected between the supply voltage Vcc and the base terminal of the transistor Q2 and another series of a PMOS transistor M4 and a capacitor C4 connected between the supply voltage Vcc and the base terminal of the transistor Q1; two other respective capacitors C3 and C4 are placed between the input terminals INP and INN of the amplifier and the drain terminals of the transistors M3 and M4. The input voltage Vin given by V(INP)-V(INN) is present on the input terminals INP and INN. The transistors M3 and M4 are used to change the input impedance when the gain of the amplifier decreases while the capacitors C3 and C4 are used for decoupling from the direct current but also to keep the transistors M3 and M4 in the triode region with the voltage Vds between the drain terminals and of source equal to zero for all the values of voltage VAGC.

The input resistor is given by:

$$R_{in} \approx R_{in1} /\!/ R_{in2} = \left( \frac{2}{k_p \left( \frac{W}{L} \right)_{3,4} |V_{GS3,4} - V_{T,p}|} \right) /\!/ \frac{2 R_F}{A_{V \, loop}}$$

where the parameter kp depends on the mobility of the charges and on the capacity of the layer of gate oxide of the PMOS M3 and M4, the parameter $(W/L)_{3,4}$ is the form ratio of the transistors M3 and M4, the voltage $V_{GS3,4}$ is the voltage between the gate and source terminals of the transistors M3 and M4, the voltage $V_T$ is the thermal voltage of the PMOS transistors,

$$A_{V\,loop} = Gm_{eq} \cdot R_C = \frac{g_{m1,2}}{1 + g_{m1,2} \cdot R_{E,eq}} R_C$$

and

$$R_{E,eq} = RE // \left( \frac{1}{2 \cdot k_n \cdot \left(\frac{W}{L}\right)_{1,2} \left(V_{GS,n} - V_T\right)} \right)$$

in which $g_{m1,2}$ is the transconductance of the couple of transistors Q1-Q2, the parameter $k_n$ depends on the mobility of the charges and on the capacity of the layer of gate oxide of the transistors M1 and M2, the voltage $V_{GS,n}$ is the voltage between the gate and source terminals of the transistors M1 and M2 and the voltage $V_T$ is the thermal voltage of the NMOS transistors M1 and M2. To obtain the coupling of the input resistor $R_{in}$ it is necessary to make it equal to the differential source resistance that is the source resistance of the input signal Vin.

In conditions of maximum gain, that is when VAGC=Vcc, the amplifier is based on the differential cascode stage, Q1-Q4, and on the followers Q5 and Q6. The resistors RF1 and RF2 produce a feedback parallel-parallel configuration. In this manner the input impedance is well controlled and a low noise pattern is obtained.

The voltage gain $A_{V,\,loop}$ in case of maximum gain $A_{Vmax}$ that is placing VAGC=Vcc is:

$$A_{V\,max} = \frac{V(OUTP) - V(OUTN)}{V(INP) - V(INN)}\bigg|_{VAGC=Vcc} = g_{m1,2} \cdot R_C$$

and the input resistance in this case is

$$R_{in} \approx \frac{2\,R_F}{A_{V\,loop}} = \frac{2 \cdot R_F}{g_{m1,2} \cdot R_C}.$$

Thanks to the stable bias current in the transistors Q1 and Q2 it results that the gain $A_V$ is given by the ratio between the resistors made in polysilicon and the emitter areas. This means that in the maximum gain configuration the tolerance on the input impedance is approximately +/-20% that permits return losses higher than -15dB to be obtained.

Leaving aside several minimum contributions in high frequency, the noise pattern F is

$$F = \left[1 + \frac{r_{b1,2} + r_{e1,2}}{R_S} + \frac{R_S}{R_F} + \frac{1}{2}\left(\frac{1}{g_{m1,2}R_S} + \frac{g_{m1,2}R_S}{\beta_F}\right)\right]$$

where with the resistance $r_{b1,2}$ is base resistance of the transistors Q1 and Q2, the resistance $R_S$ is the source resistance, the parameter $\beta_F$ is the current gain of the transistors Q1 and Q2. The input linearity is given by $2V_T$.

In the configuration with minimum voltage gain $A_{V,\,loop}$ indicated by $A_{Vmin}$, in the configuration in which VAGC=0V, the emitter resistance is at the maximum value; it results:

$$A_{V\,min} = \left.\frac{V(OUTP) - V(OUTN)}{V(INP) - V(INN)}\right|_{VAGC=0V} = 2 \cdot \frac{R_C}{R_E}$$

while the input linearity is $R_E I_{E1,2}$.

Considering the input coupling, in said conditions the feedback is disabled and the input impedance is fixed by the PMOS transistors M3 and M4 in the triode region, connected in parallel to the input. It results:

$$R_{in} \approx \left( \frac{2}{k_p \left(\frac{W}{L}\right)_{3,4} |V_{GS3,4} - V_{T,P}|} \right)$$

Selecting appropriately the ratio (W/L) of the transistors M3 and M4 it is possible to keep good return losses and a minimum gain. With the amplifier at minimum gain a tolerance of 30% on the input resistance can be obtained that permits return losses of -15dB to be obtained.

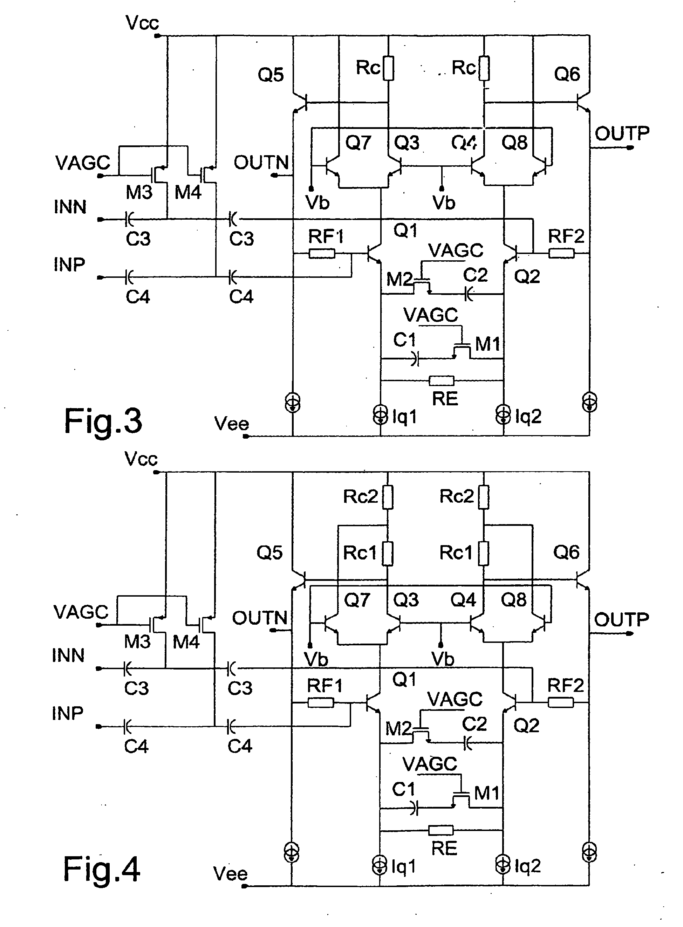

Another circuit implementation of the amplifier according to a variant of the first embodiment of the invention is that shown in Figure 3. The amplifier of Figure 3 differs from the amplifier of Figure 2 for the presence of other two bipolar npn transistors Q7 and Q8 having the emitter terminals connected to the transistors Q3 and Q4, the collector terminals connected to the supply voltage Vcc and the base terminals connected to the voltage Vb.

A further circuit implementation of the amplifier according to another variant of the first embodiment of the invention is that shown in Figure 4. The amplifier of Figure 4 differs from the amplifier of Figure 3 because the resistors Rc are constituted by two resistors Rc1 and Rc2 in series and the collector terminals of the transistors Q7 and Q8 are connected to the common terminal of the resistors Rc1 and Rc2. In this manner, given that Rc=Rc1+Rc2, we have $A_{vmin}$=2*Rc2/Re.

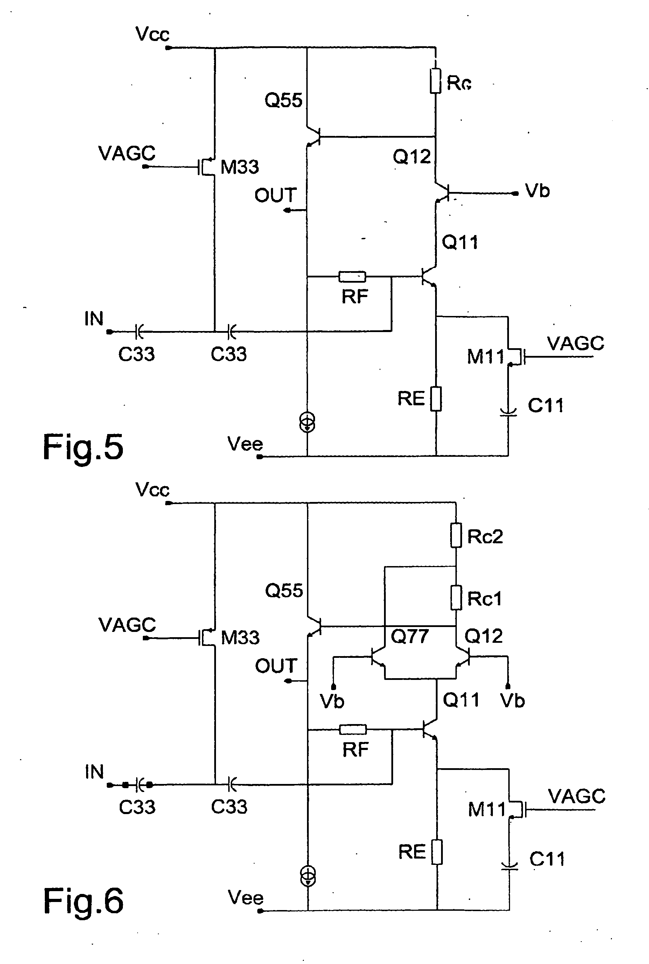

Yet another circuit implementation of the amplifier according to a second embodiment of the invention is shown in Figure 5. The circuit block 1 comprises a differential cascode apparatus formed by the bipolar npn transistors Q11-Q12. The transistors Q11, Q12 have the respective collector and emitter terminals in common, the emitter terminal of the transistor Q11 is connected to the resistor RE connected in turn to the voltage Vee while the collector terminal of the transistor Q12 is connected to a resistor Rc connected to the supply Vcc. The first circuit means 2 are made up of a series of a NMOS transistor M11 and a capacitor C11 placed between the emitter terminal of the transistor Q11 and the voltage Vee; the transistor M11 is controlled by the voltage VAGC. The transistor M11 is used to change the value of the degeneration resistance connected to the emitter terminal of the transistor Q11 by a value 0 (with VAGC=Vcc and M11 short-circuited) to a value RE (with VAGC=0 and M11 open). The capacitor C11 is used to keep the transistor M11 in the triode region in the conditions in which the voltage VAGC is between the values 0 and Vcc.

The amplifier comprises a bipolar npn transistor Q55 whose base terminal is connected to the collector terminal of the transistor Q12, whose collector terminal is connected to the supply voltage Vcc and the emitter terminal, that constitutes the output OUT of the amplifier, is connected to the base terminal of the transistor Q11 by means of a resistor RF and to a bias current generator.

The second circuit means 3 comprise a series of a PMOS transistor M33 and a capacitor C33 connected between the supply voltage Vcc and the base terminal of the transistor Q11; another capacitor C33 is placed between the input terminal IN of the amplifier and the drain terminals of the transistor M33. The transistor M33 is used to change the input impedance when the gain of the amplifier decreases while the capacitors C33 are used for decoupling from the direct current but also to keep the transistor M33 in the triode region with the voltage Vds between the drain and source terminals equal to zero for all the values of voltage VAGC.

A further circuit implementation of the amplifier according to a variant of the second embodiment of the invention is that shown in Figure 6. The amplifier of Figure 6 differs from the amplifier of Figure 5 because the resistor Rc is constituted by two resistors Rc1 and Rc2 in series and because of the presence of a transistor Q77 whose collector terminal is connected to the common terminal of the resistors Rc1 and Rc2, the base terminal connected to the bias voltage Vb and the emitter terminal connected to the emitter terminal of the transistor Q12.

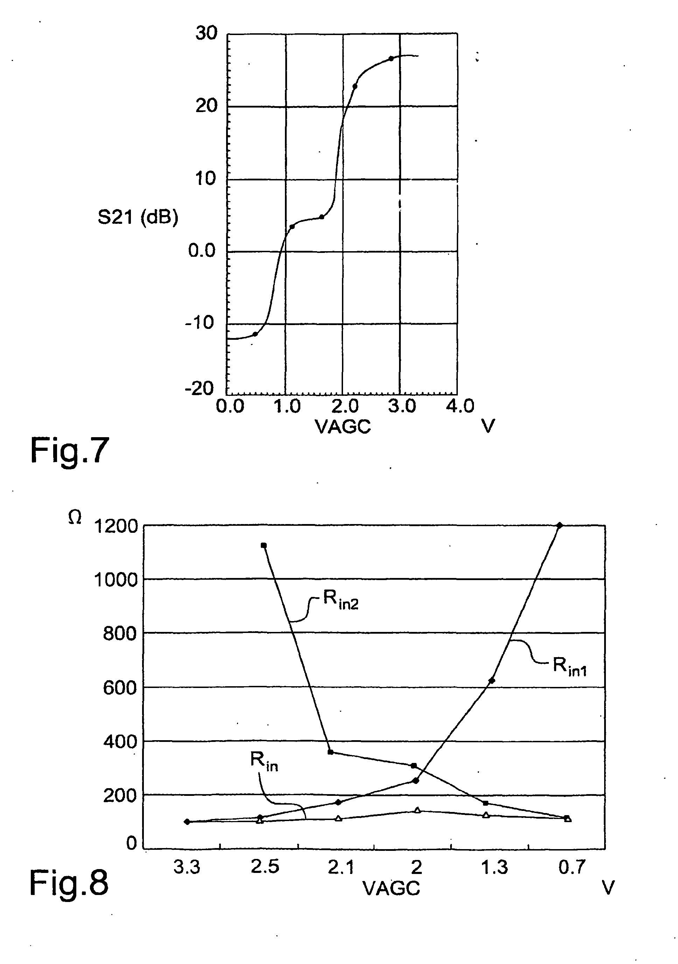

From simulations carried out on the circuit of Figure 4, considering the values $K_p$=2,35*10$^{-5}$, $V_{T,p}$=0,6V and $(W/L)_{3,4}$=130/0.35, RF=1500Ohm a signal gain S21 between output and input is obtained variable from 26dB to -12dB for an interval of voltages VAGC variable from 3V to 0V, as seen in Figure 7.

In Figure 8 a graph of the resistances $R_{in1}$, $R_{in2}$ and $R_{in}$ upon variation of the voltage VAGC is shown; we have

the input resistor $R_{in}$ keeps substantially constant around a value of 1000hm.

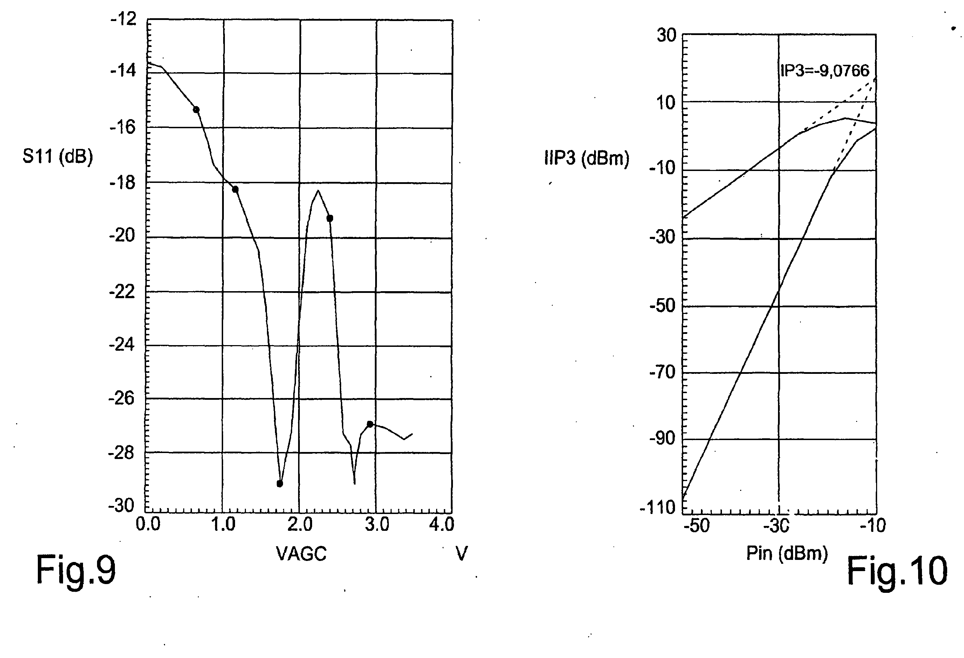

In Figure 9 a graph of the return losses S 11 in decibel is shown for a variation of the voltage VAGC from 0 to 3V; we have that S11 varies from almost -14dB to -29dB.

In Figure 10 the graph of the intercept of the third order IIP3 is given, that is the third harmonic intercept referred to the input (Input Intercept Point 3), in dBm in function of the input power Pin in dBm in case of maximum gain, VAGC=Vcc; we have the intercept point IP3=-9,0766.

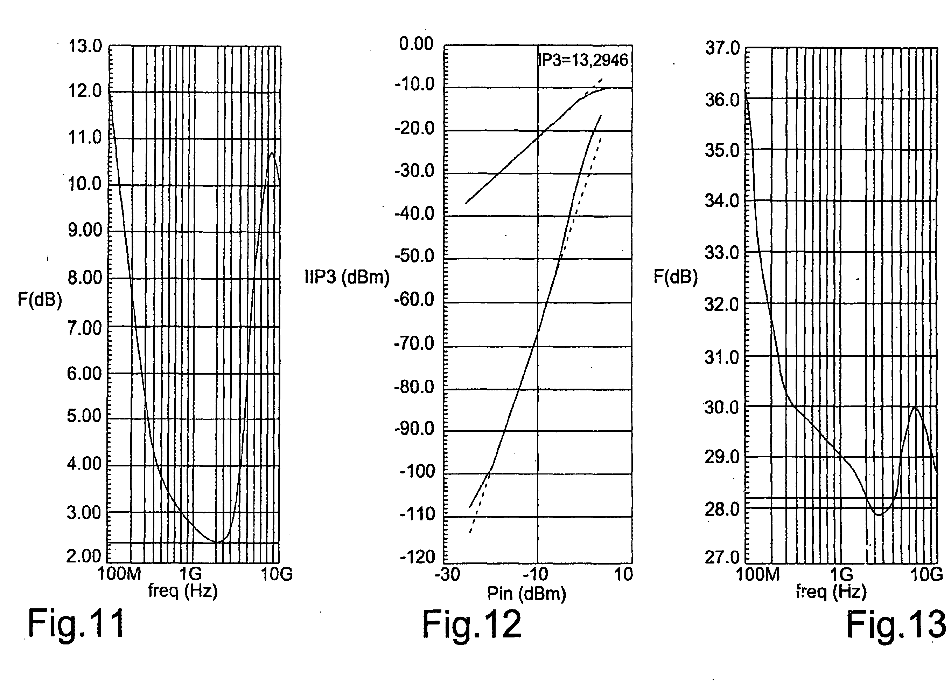

In Figure 11 the graph of the noise pattern F in decibel is shown in function of the frequency freq in case of maximum gain, VAGC=Vcc. A= Figures 12 and 13 give graphs of the intercept of the third order IIP3 and of the noise pattern F in case of minimum gain, VAGC=0; we have IP3=13,2946.

## Claims

1. Low noise amplifier comprising at least a first circuit block (1, Q1-Q4, Q11-Q12) capable of amplifying a first voltage signal (Vin, V(INP)-V(INN)) in input to the amplifier, said first circuit block (1, Q1-Q4, Q11-Q12) having at least one first terminal coupled to a first supply voltage (Vee) by means of first variable resistor means (RE,2) and at least one second terminal coupled with a second supply voltage (Vcc) by means of at least one resistor (Rc, Rc1, Rc2), said at least one second terminal being coupled to the at least one output terminal of the amplifier (OUT, OUTP-OUTN) and said input voltage signal (Vin, V(INP)-V(INN)) being applied to at least one further terminal (IN, INP-INN) of the first circuit block, said amplifier comprising a feedback network (RF, RF1, RF2) coupled to said at least one output terminal (OUT, OUTP-OUTN) of the amplifier and to said at least one further terminal (IN, INP-INN) of the first circuit block, **characterised in that** it comprises second circuit means (3) placed between said second supply voltage (Vcc) and said at least one further terminal (IN, INP-INN) of the first circuit block and adapted to compensate the variations in value of said first variable resistor means (RE,2) to ensure a substantially constant input resistance ($R_{in}$) of said amplifier.

2. Amplifier according to claim 1, **characterised in that** said first variable resistor means (RE,2) are controlled by a further voltage signal (VAGC) and said second circuit means (3) are controlled by the same further voltage signal (VAGC).

3. Amplifier according to claim 2, **characterised in that** said first variable resistor means (RE, 2) comprise at least one resistor (RE) and at least one transistor (M1, M2, M11) having the not-driveable terminals connected to the ends of said resistor (RE), said transistor being driven by said further voltage signal (VAGC).

4. Amplifier according to claim 3, **characterised in that** said at least one transistor (M1, M2, M11) is a MOS transistor and said first variable resistor means (RE, 2) comprise at least one capacitor (C1, C2, C11) adapted to make said transistor operate in the triode region.

5. Amplifier according to one of the claims from 2 to 4, **characterised in that** said second circuit means (3) comprise at least one transistor (M3, M4, M33) driven by said further voltage signal (VAGC).

6. Amplifier according to claim 5, **characterised in that** said at least one transistor (M3, M4, M33) of said second circuit means (3) is a MOS transistor and said second means (3) comprise at least one capacitor (C3, C4, C33) adapted to make said transistor operate in the triode region.

7. Amplifier according to claim 5, **characterised in that** the at least one transistor (M3, M4, M33) of said second means (3) is a PMOS transistor and the at least one transistor (M1, M2, M11) of said first variable resistor means (RE, 2) is a NMOS transistor.

8. Amplifier according to claim 1, **characterised in that** said feedback network (RF, RF1, RF2) comprises at least one resistor.

9. Amplifier according to claim 1, **characterised in that** it comprises a buffer (4) placed between said at least one second terminal of the first circuit block (1, Q1-Q4, Q11-Q12) and said at least one output terminal (OUT, OUTP-OUTN) of the amplifier.

10. Amplifier according to one of the previous claims, **characterised in that** said first circuit block (Q1-Q4) comprises four transistors placed according to a differential cascode configuration in which a first (Q1) and a second (Q2) transistor are placed according to one differential stage and a third (Q3) and a fourth (Q4) transistor are connected to said first (Q1) and second (Q2) transistor to produce said cascode configuration, said first circuit block having two first terminals that coincide with two not-driveable terminals of said first (Q1) and second (Q2) transistor, two second terminals that coincide with the not-driveable terminals of said third (Q3) and fourth (Q4) transistor and two further terminals that coincide with the drivable terminals of said first (Q1) and second (Q2) transistor, said amplifier having two input terminals and two output terminals.

11. Amplifier according to claim 10, **characterised in that** it comprises two series of a first (Rc1) and a second (Rc2) resistor connected to said two second terminals of the first circuit block, two further transistors (Q7, Q8) having two not-driveable terminals connected to the not-driveable terminals of said third (Q3) and fourth (Q4) transistor to produce with them two differential stages, the two other not-driveable terminals of said further transistors being connected to the common terminals of the resistors of said series.

12. Amplifier according to any of the claims from 1 to 9, **characterised in that** said first circuit block (1) comprises two transistors (Q11, Q12) connected in cascode configuration, a first (Q11) of said two transistors having the input terminal coupled with the input terminal of the amplifier, said first circuit block having a first terminal that coincides with a not-driveable terminal of a first (Q11) of said two transistors, a second terminal that coincides with a not-drivable terminal of the second (Q12) of said two transistors and a further terminal that coincides with a drivable terminal of said first (Q11) transistor, said amplifier having an input terminal and an output terminal.

13. Amplifier according to claim 12, **characterised in that** it comprises a series of a first (Rc1) and a second (Rc2) resistor connected to the second terminal of the first circuit block, a further transistor (Q77) having a not-drivable terminal connected to the not-drivable terminal of said second transistor (Q12) to produce with it a differential stage, the other not-drivable terminal of said further transistor being connected to the common terminal of the resistors of said series.

**Patentansprüche**

1. Rauscharmer Verstärker mit mindestens einem zum Verstärken eines dem Verstärker zugespeisten ersten Spannungssignals (Vin, V(INP)-(INN)) geeigneten ersten Schaltungsblock (1, Q1-Q4, Q11-Q12), wobei der erste Schaltungsblock (1), Q1-Q4, Q11-Q12) mindestens einen mittels einer ersten veränderlichen Widerstandseinrichtung (RE, 2) mit einer ersten Versorgungsspannung (Vee) gekoppelten ersten Anschluss und mindestens einen mittels mindestens eines Widerstandes (Rc, Rc1, Rc2) mit einer zweiten Versorgungsspannung (Vcc) gekoppelten zweiten Anschluss aufweist, wobei der mindestens eine zweite Anschluss mit dem mindestens einen Ausgangsanschluss des Verstärkers (OUT, OUTP-OUTN) gekoppelt ist und wobei das Eingangsspannungssignal (Vin, V(INP)-V(INN)) mindestens an einen weiteren Anschluss (IN, INP-INN) des ersten Schaltungsblockes angelegt ist, wobei der Verstärker ein mit dem mindestens einen Ausgangsanschluss (OUT, OUTP-OUTN) des Verstärkers und mit dem mindestens einen weiteren Anschluss (IN, INP-INN) des ersten Schaltungsblockes gekoppeltes Rückkopplungsnetzwerk (RF, RF1, RF2) aufweist,
**dadurch gekennzeichnet, dass** er eine zweite Schaltungseinrichtung (3) aufweist, die zwischen der zweiten Versorgungsspannung (Vcc) und dem mindestens einen weiteren Anschluss (IN, INP-INN) des ersten Schaltungsblockes angeordnet und eingerichtet ist, so dass sie einen im Wesentlichen konstanten Eingangswiderstand ($R_{in}$) des Verstärkers sicherstellt.

2. Verstärker nach Anspruch 1, **dadurch gekennzeichnet, dass** die erste veränderliche Widerstandseinrichtung (RE, 2) durch ein weiteres Spannungssignal (VAGC) gesteuert wird, und dass die zweite Schaltungseinrichtung (3) durch dasselbe weitere Spannungssignal (VAGC) gesteuert wird.

3. Verstärker nach Anspruch 2, **dadurch gekennzeichnet, dass** die erste veränderliche Widerstandseinrichtung (RE, 2) mindestens einen Widerstand (RE) und mindestens einen Transistor (M1, M2, M11) aufweist, dessen nicht ansteuerbare Anschlüsse mit den Enden des Widerstandes (RE) verbunden sind, wobei der Transistor durch das weitere Spannungssignal (VAGC) angesteuert wird.

4. Verstärker nach Anspruch 3, **dadurch gekennzeichnet, dass** der mindestens eine Transistor (M1, M2, M11) ein MOS-Transistor ist und dass die erste veränderliche Widerstandseinrichtung (RE, 2) mindestens einen Kondensator (C1, C2, C11) umfaßt, der eingerichtet ist, um zu bewirken, dass der Transistor im Triodenbereich arbeitet.

5. Verstärker nach einem der Ansprüche 2 bis 4, **dadurch gekennzeichnet, dass** die zweite Schaltungseinrichtung (3) mindestens einen durch das weitere Spannungssignal (VAGC) angesteuerten Transistor (M3, M4, M33) umfasst.

6. Verstärker nach Anspruch 5, **dadurch gekennzeichnet, dass** der mindestens eine Transistor (M3, M4, M33) der zweiten Schaltungseinrichtung (3) ein MOS-Transistor ist und dass die zweite Einrichtung (3) mindestens einen Kondensator (C3, C4, C33) umfaßt, der eingerichtet ist, um zu bewirken, dass der Transistor im Triodenbereich arbeitet.

7. Verstärker nach Anspruch 5, **dadurch gekennzeichnet, dass** der mindestens eine Transistor (M3, M4, M33) der zweiten Einrichtung (3) ein PMOS-Transistor ist, und dass der mindestens eine Transistor (M1, M2, M11) der ersten veränderlichen Widerstandseinrichtung (RE, 2) ein NMOS-Transistor ist.

8. Verstärker nach Anspruch 1, **dadurch gekennzeichnet, dass** das Rückkopplungsnetzwerk (RF, RF1, RF2) mindestens einen Widerstand umfasst.

9. Verstärker nach Anspruch 1, **dadurch gekennzeichnet, dass** er einen zwischen dem mindestens einen zweiten Anschluss des ersten Schaltungsblockes (1, Q1-Q4, Q11-Q12) und dem mindestens einen Ausgangsanschluss (OUT, OUTP-OUTN) des Verstärkers angeordneten Puffer (4) aufweist.

10. Verstärker nach einem der vorstehenden Ansprüche, **dadurch gekennzeichnet, dass** der erste Schaltungsblock (Q1-Q4) vier in einer Differential-Kaskoden-Konfiguration angeordnete Transistoren aufweist, in welcher ein erster Transistor (Q1) und ein zweiter Transistor (Q2) gemäß einer Differentialstufe angeordnet sind und ein dritter Transistor (Q3) und ein vierter Transistor (Q4) mit dem ersten Transistor (01) und dem zweiten Transistor (Q2) verbunden sind, um die Kaskodenkonfiguration zu erzeugen, wobei der erste Schaltungsblock zwei erste Anschlüsse, die mit zwei nicht ansteuerbaren Anschlüssen des ersten Transistors (Q1) und des zweiten Transistors (Q2) übereinstimmen, zwei zweite Anschlüsse, die mit den nicht-ansteuerbaren Anschlüssen des dritten Transistors (Q3) und des vierten Transistors (Q4) übereinstimmen, und zwei weitere Anschlüsse, die mit den ansteuerbaren Anschlüssen des ersten Transistors (Q1) und des zweiten Transistors (Q2) übereinstimmen, aufweist, wobei der Verstärker zwei Eingangsanschlüsse und zwei Ausgangsanschlüsse aufweist.

11. Verstärker nach Anspruch 10, **dadurch gekennzeichnet, dass** er aufweist: zwei Reihenschaltungen eines ersten Widerstandes (Rc1) und eines zweiten Widerstandes (Rc2), die mit den beiden zweiten Anschlüssen des ersten Schaltungsblockes verbunden sind, zwei weitere Transistoren (Q7, Q8), die zwei mit den nicht ansteuerbaren Anschlüssen des dritten Transistors Q3 und des vierten Transistors Q4 verbundene nicht-ansteuerbare Anschlüsse aufweisen, um mit ihnen zwei Differentialstufen zu bilden, wobei die beiden anderen nicht-ansteuerbaren Anschlüsse der weiteren Transistoren mit den gemeinsamen Anschlüssen der Widerstände der Reihenschaltungen verbunden sind.

12. Verstärker nach irgendeinem der Ansprüche 1 bis 9, **dadurch gekennzeichnet, dass** der erste Schaltungsblock (1) zwei in Kaskode-Konfiguration verbundene Transistoren (Q11, Q12) aufweist, wobei der Eingangsanschluss des ersten Transistors (Q11) der beiden Transistoren mit dem Eingangsanschluss des Verstärkers gekoppelt ist, wobei der erste Schaltungsblock einen ersten Anschluss, der mit einem nicht-ansteuerbaren Anschluss eines ersten Transistors (Q11) der beiden Transistoren übereinstimmt, einen zweiten Anschluss, der mit einem nicht-ansteuerbaren Anschluss des zweiten Transistors (Q12) der beiden Transistoren übereinstimmt, und einen weiteren Anschluss, der mit einem ansteuerbaren Anschluss des ersten Transistors (Q11) übereinstimmt, aufweist, wobei der Verstärker einen Eingangsanschluss und einen Ausgangsanschluss hat.

13. Verstärker nach Anspruch 12, **dadurch gekennzeichnet, dass** er eine mit dem zweiten Anschluss des ersten Schaltungsblockes verbundene Reihenschaltung eines ersten Widerstandes (Rc1) und eines zweiten Widerstandes (Rc2) aufweist, wobei ein nicht-ansteuerbarer Anschluss eines weiteren Transistors (Q77) mit dem nicht-ansteuerbaren Anschluss des zweiten Transistors (Q12) verbunden ist, um mit ihm eine Differentialstufe zu bilden, wobei der andere nicht-ansteuerbare Anschluss des weiteren Transistors mit dem gemeinsamen Anschluss der Widerstände der Reihenschaltung verbunden ist.

**Revendications**

1. Amplificateur à faible bruit comprenant au moins un premier bloc de circuit (1, Q1-Q4, Q11-Q12) capable d'amplifier un premier signal de tension (Vin, V(INP)-V(INN)) en entrée de l'amplificateur, ledit premier bloc de circuit (1, Q1-Q4, Q11-Q12) ayant au moins une première borne couplée à une première tension d'alimentation (Vee) par l'intermédiaire d'un premier moyen formant résistance variable (RE, 2) et au moins une deuxième borne couplée à une deuxième tension d'alimentation (Vcc) par l'intermédiaire d'au moins une résistance (Rc, Rc1, Rc2), ladite au moins une deuxième borne étant couplée à ladite au moins une borne de sortie de l'amplificateur (OUT, OUTP-OUTN) et ledit signal de tension d'entrée (Vin, V(INP)-V(INN)) étant appliqué à au moins une autre borne (IN, INP-INN) du premier bloc de circuit, ledit amplificateur comprenant une chaîne de rétroaction (RF, RF1, RF2) couplée à ladite au moins une borne de sortie (OUT, OUTP-OUTN) de l'amplificateur et à ladite au moins une autre borne (IN, INP-INN) du premier bloc de circuit, **caractérisé en ce qu'**il comprend un deuxième moyen de circuit (3) placé entre ladite deuxième tension d'alimentation (Vcc) et ladite au moins une autre borne (IN, INP-INN) du premier bloc de circuit et adapté pour compenser les variations en valeur dudit premier moyen formant résistance variable (RE, 2) pour assurer une résistance d'entrée sensiblement constante ($R_{in}$) dudit amplificateur.

2. Amplificateur selon la revendication 1, **caractérisé en ce que** ledit premier moyen formant résistance variable (RE, 2) est commandé par un signal de tension supplémentaire (VAGC) et ledit deuxième moyen de circuit (3) est commandé par le même signal de tension supplémentaire (VAGC).

3. Amplificateur selon la revendication 2, **caractérisé en ce que** ledit premier moyen formant résistance variable (RE, 2) comprend au moins une résistance (RE) et au moins un transistor (M1, M2, M11) dont les bornes non commandables sont connectées aux extrémités de ladite résistance (RE), ledit transistor étant commandé par ledit signal de tension supplémentaire (VAGC).

4. Amplificateur selon la revendication 3, **caractérisé en ce que** ledit au moins un transistor (M1, M2, M11) est un transistor MOS et ledit premier moyen formant résistance variable (RE, 2) comprend au moins un condensateur (C1, C2, C11) adapté pour faire fonctionner ledit transistor dans le domaine triode.

5. Amplificateur selon l'une des revendications 2 à 4, **caractérisé en ce que** ledit deuxième moyen de circuit (3) comprend au moins un transistor (M3, M4, M33) commandé par ledit signal de tension supplémentaire (VAGC).

6. Amplificateur selon la revendication 5, **caractérisé en ce que** ledit au moins un transistor (M3, M4, M33) dudit deuxième moyen de circuit (3) est un transistor MOS et ledit deuxième moyen (3) comprend au moins un condensateur (C3, C4, C33) adapté pour faire fonctionner ledit transistor dans le domaine triode.

7. Amplificateur selon la revendication 5, **caractérisé en ce que** ledit au moins un transistor (M3, M4, M33) dudit deuxième moyen (3) est un transistor PMOS et ledit au moins un transistor (M1, M2, M11) dudit premier moyen formant résistance variable (RE, 2) est un transistor NMOS.

8. Amplificateur selon la revendication 1, **caractérisé en ce que** ladite chaîne de rétroaction (RF, RF1, RF2) comprend au moins une résistance.

9. Amplificateur selon la revendication 1, **caractérisé en ce qu'**il comprend un tampon (4) placé entre ladite au moins une deuxième borne du premier bloc de circuit (1, Q1-Q4, Q11-Q12) et ladite au moins une borne de sortie (OUT, OUTP-OUTN) de l'amplificateur.

10. Amplificateur selon l'une des revendications précédentes, **caractérisé en ce que** ledit premier bloc de circuit (Q1-Q4) comprend quatre transistors placés selon une configuration de cascode différentiel dans laquelle un premier (Q1) et un deuxième (Q2) transistor sont placés selon un étage différentiel et un troisième (Q3) et un quatrième (Q4) transistor sont reliés auxdits premier (Q1) et deuxième (Q2) transistors pour produire ladite configuration de cascode, ledit premier bloc de circuit ayant deux premières bornes qui coïncident avec deux bornes non commandables desdits premier (Q1) et deuxième (Q2) transistors, deux deuxièmes bornes qui coïncident avec les bornes non commandables desdits troisième (Q3) et quatrième (Q4) transistors et deux bornes supplémentaires qui coïncident avec les bornes commandables desdits premier (Q1) et deuxième (Q2) transistors, ledit amplificateur ayant deux bornes d'entrée et deux bornes de sortie.

11. Amplificateur selon la revendication 10, **caractérisé en ce qu'**il comprend deux séries d'une première (Rc1) et d'une deuxième (Rc2) résistance connectées auxdites deux deuxièmes bornes du premier bloc de circuit, deux transistors supplémentaires (Q7, Q8) ayant deux bornes non commandables reliées aux bornes non commandables desdits troisième (Q3) et quatrième (Q4) transistors pour produire avec eux deux étages différentiels, les deux autres bornes non commandables desdits transistors supplémentaires étant reliées aux bornes communes des résistances desdites séries.

12. Amplificateur selon l'une des revendications 1 à 9, **caractérisé en ce que** ledit premier bloc de circuit (1) comprend deux transistors (Q11, Q12) montés en configuration de cascode, un premier (Q11) desdits deux transistors ayant sa borne d'entrée couplée à la borne d'entrée de l'amplificateur, ledit premier bloc de circuit ayant une première borne qui coïncide avec une borne non commandable d'un premier (Q11) desdits deux transistors, une deuxième borne qui coïncide avec une borne non commandable du deuxième (Q12) desdits deux transistors et une borne supplémentaire qui coïncide avec une borne commandable dudit premier (Q11) transistor, ledit amplificateur ayant une borne d'entrée et une borne de sortie.

13. Amplificateur selon la revendication 12, **caractérisé en ce qu'**il comprend une série d'une première (Rc1) et d'une deuxième (Rc2) résistance connectées à la deuxième borne du premier bloc de circuit, un transistor supplémentaire (Q77) ayant une borne non commandable reliée à la borne non commandable dudit deuxième transistor (Q12) pour produire avec ce dernier un étage différentiel, l'autre borne non commandable dudit transistor supplémentaire étant reliée à la borne commune des résistances de ladite série.

## Fig.1

## Fig.2

Vcc

Q5    Rc    Rc    Q6

VAGC

M3  M4

INN

C3    C3

INP

C4    C4

OUTN

Q7  Q3  Q4  Q8

Vb    Vb

RF1    Q1

VAGC

M2    C2    Q2

VAGC

C1    M1

RE

RF2

OUTP

Iq1    Iq2

Vee

**Fig.3**

Vcc

Rc2    Rc2

Rc1    Rc1

Q5    Q6

VAGC

M3  M4

INN

C3    C3

INP

C4    C4

OUTN

Q7  Q3  Q4  Q8

Vb    Vb

RF1    Q1

VAGC

M2    C2    Q2

VAGC

C1    M1

RE

RF2

OUTP

Iq1    Iq2

Vee

**Fig.4**

Fig.5

Fig.6

Fig.7

Fig.8

Fig.9

Fig.10

IP3=-9,0766

EP 1 630 951 B1

Fig.13

F(dB)

freq (Hz)

Fig.12

IIP3 (dBm)

IP3=13,2946

Pin (dBm)

Fig.11

F(dB)

freq (Hz)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6600371 B

- US 6559717 B